# EUROPÄISCHE PATENTSCHRIFT

(11) **EP 1 925 192 B1**
(45) Veröffentlichungstag und Bekanntmachung des Hinweises auf die Patenterteilung: **25.04.2012**
(21) Anmeldenummer: 06791940.7
(22) Anmeldetag: 08.09.2006
(51) Int. Cl.: H05K 3/00, H05K 3/20, H05K 3/40, H05K 3/46, H05K 3/32, H01L 23/50, H01L 23/495, H01L 23/498, H01L 21/48

(54) **LAMINIERTES SUBSTRAT FÜR DIE MONTAGE VON ELEKTRONISCHEN BAUTEILEN**
LAMINATED SUBSTRATE FOR MOUNTING ELECTRONIC PARTS
SUBSTRAT LAMINE DESTINE AU MONTAGE DE COMPOSANTS ELECTRONIQUES

(30) Priorität: 14.09.2005 DE 102005044001
(43) Veröffentlichungstag der Anmeldung: 28.05.2008
(73) Patentinhaber: Heraeus Materials Technology GmbH & Co. KG, 63450 Hanau (DE)
(72) Erfinder: DITZEL, Eckhard, 63589 Linsengericht (DE); WALTER, Siegfried, 63571 Gelnhausen-Höchst (DE); GRESCH, Manfred, 61267 Neu-Anspach (DE)
(74) Vertreter: Kühn, Hans-Christian
(86) Internationale Anmeldenummer: PCT/EP2006/008783
(87) Internationale Veröffentlichungsnummer: WO 2007/031241

(56) Entgegenhaltungen:
- EP-A1- 0 296 511
- EP-A2- 1 334 820
- DE-A1- 3 017 320
- DE-A1- 3 306 120
- DE-A1- 19 521 022
- DE-C1- 4 340 996

## Beschreibung

Die vorliegende Erfindung betrifft Verfahren zur Herstellung laminierter Substrate für die Halbleiter-Chip-Montage aus mindestens je einer strukturierten Metall- und Kunststofffolie sowie bandförmige Laminate als Vorstufe der Substrate.

EP 0296511 offenbart ein Verfahren nach dem Oberbegriff von Anspruch 1.

Nach DE 195 21 022 werden eine Metallfolienbahn und eine Kunststofffolienbahn separat gestanzt und danach miteinander zu einem "Endlosband" verklebt, wobei vorzugsweise Führungsdorne in übereinander liegende Positionsmarkierungen der miteinander zu verklebenden Folienbahnen eingreifen.

Für Reinstraum-Anwendungen ist der beim Vereinzeln der Substrate auftretende Abrieb des Laminats eine unerwünschte Kontamination.

Problematisch ist auch die Empfindlichkeit der immer kleiner werdenden elektronischen Bauteile gegen mechanische Belastungen.

Es ist die Aufgabe der vorliegenden Erfindung, elektronische Bauteile besser gegen mechanische Belastungen zu schützen, die Kontamination durch Laminatabrieb beim Vereinzeln zu lindern, Vereinfachungen für die Verarbeitung von derartigen Laminatsubstraten zu schaffen und flexiblere Anwendungsmöglichkeiten der Substrate zu ermöglichen.

Zur Lösung der Aufgabe sind die folgenden Merkmale geeignet:
A) Die Folien werden so strukturiert, dass sich bei deren Anordnung übereinander solche Bereiche ergeben, über deren gesamte Breite keine Überlappung erfolgt.
B) Die Folien werden in wiederholenden Teilbereichen über die gesamte Breite des Laminats nicht laminiert.
C) Aus dem Laminat werden sich wiederholende Abschnitte der sich wiederholenden Konturen aus der Bandfläche des Laminats gebogen.

Erfindungsgemäße Lösungen sind in den unabhängigen Ansprüchen 1 und 9 beschrieben. Bevorzugte Ausführungen finden sich in den abhängigen Ansprüchen.

Werden Folien gemäß Merkmal A) oder B) so strukturiert, dass sich bei deren Anordnung übereinander solche Bereiche ergeben, über deren gesamte Breite keine Überlappung oder Laminierung erfolgt, ermöglichen diese Bereiche eine vollständige Entfernung einer oder mehrerer Folien über die gesamte Breite des Laminatbandes, so dass das Laminatband in diesem Bereich ausschließlich aus der oder den verbleibenden Folien besteht und sämtliche Strukturierungsschritte an nicht laminiertem Material erfolgen.

Es wird somit ein bandförmiges Laminat aus mindestens je einer strukturierten Metall- und Kunststofffolie bereitgestellt, dessen Folien jeweils unterschiedliche sich wiederholende Konturen aufweisen, und das Bereiche aufweist, in denen die strukturierten Folien über die gesamte Breite des Bandes nicht überlappen oder eine Folie des Laminats in nicht zusammenhängende Konturen strukturiert ist.

Werden aus dem Laminat gemäß Merkmal C) sich wiederholende Abschnitte der sich wiederholenden Muster aus der Bandfläche des Laminats gebogen, werden dabei freie Bereiche in der Bandfläche des Laminats geschaffen mit denen einerseits wiederum die gleiche Wirkung wie mit Merkmalen A) und B) erzielbar ist, nämlich das Entfernen einer oder mehrerer Folien über die gesamte Breite des Laminatbandes unter Aufrechterhaltung einer oder mehrerer Folien. Andererseits sind die gebogenen Abschnitte dazu geeignet, aufzunehmende Bauteile zu fixieren und vor mechanischer Belastung zu schützen.

Aus der Bandfläche herausragende Laschen sind anfällig für Beschädigungen beim Aufrollen des Bandes und neigen zum Verhaken beim Abrollen des Bandes. Diese Probleme können mit Abstandshaltern ausgeräumt werden. Es wird somit ein bandförmiges Laminat aus mindestens je einer strukturierten Metall- und Kunststofffolie bereitgestellt, dessen Folien jeweils unterschiedliche sich wiederholende Konturen aufweisen, und das aus seiner Basisfläche gebogene Abschnitte aufweist, die insbesondere als Laschen oder Abstandshalter ausgebildet sind.

In einer Ausführung werden mehrere Laschen als Banden oder Seitenwände einer Halterung, insbesondere Fassung, angeordnet.

Die Laschen, insbesondere in Form einer Halterung angeordnet, ermöglichen eine besonders präzise Bestückung. Um die gebotene Präzision voll auszuschöpfen, werden Referenzlöcher in einen nicht laminierten Bereich einer Folie, insbesondere einer Metallfolie, gestanzt, deren Toleranz gegenüber den bekannten laminierten Führungslöchern kleiner gehalten werden kann. Löcher in einem nichtlaminierten Bereich sind als Referenzlöcher besonders geeignet, da ihre Toleranz von ± 0,01 mm gegenüber den bekannten Positionsmarkierungen (Führungslöcher) (Toleranz: ± 0,03 mm) nochmals deutlich verringert ist und eine genauere Einpassung der elektronischen Bauteile ermöglicht. Es hat sich bewährt, nach dem Laminieren Referenzlöcher zu stanzen.

Alle diese Laminate eignen sich zur Bereitstellung laminierter Substrate für die Halbleiterchip-Montage und sind Zwischenprodukte in Verfahren zur Herstellung von Substraten mit jeweils mindestens einer strukturierten Metall- und Kunststofffolie.

In einem Verfahren werden aus diesem Laminat sich wiederholende Abschnitte der sich wiederholenden Konturen aus der Bandfläche des Laminats gebogen, insbesondere werden wiederholende Abschnitte zu Laschen oder Abstandshaltern gebogen.

Erfindungsgemäß werden die Folien so strukturiert, dass sich bei deren Anordnung übereinander solche Bereiche ergeben, über deren gesamte Breite keine Überlappung erfolgt. Entsprechend werden die Folien in wiederholenden Teilbereichen über die gesamte Breite des Laminats nicht laminiert.

Ein maßgebliches Verfahren besteht darin, dass eine Folie des Laminatbandes in nicht zusammenhängende Konturen getrennt wird. Dies ermöglicht, dass bandförmige Laminate zur Vereinzelung zu Substraten in den Bereichen getrennt werden, in denen eine Folie unterbrochen wurde.

In Ausführungen
- sind die laminierten Substrate Träger für Halbleiterchips;
- ist die strukturierte Metallfolie gestanzt oder geätzt;
- ist die Kunststofffolie gestanzt;
- ist die Kunststofffolie faserverstärkt, insbesondere glasfaserverstärkt;
- werden die jeweils unterschiedlichen, sich wiederholenden Konturen in einer Stanzeinrichtung mit austauschbarem Stanzteil gestanzt;
- erfolgt in der Metallfolie ein Freischnitt, um die späteren Laschen freizulegen;
- erfolgt das Stanzen der Kontur für die späteren Abstandshalter in die Metallfolie ohne Freischnitt;
- werden Führungslöcher zum Ausrichten der Folien aufeinander mit dem gleichen Stanzwerkzeug sowohl in die Metallfolie als auch in die Kunststofffolie gestanzt;
- werden in die Kunststofffolie Freischnitte in Bereiche gestanzt, die um die späteren Laschen angeordnet werden;
- werden in die Kunststofffolie Freischnitte in Bereiche gestanzt, die um die späteren Abstandshalter angeordnet werden;
- werden in die Kunststofffolie Freischnitte in Bereiche gestanzt, die um die späteren Referenzlöcher angeordnet werden;
- werden am Rand der Kunststofffolie Ausnehmungen gestanzt;
- werden die jeweils unterschiedlichen, sich wiederholenden Konturen in einer Stanzeinrichtung mit austauschbaren Stanzmodulen gestanzt;
- werden die Folien mit einem Haftmittel zu einem Band laminiert;
- erzeugen die Schnitte Abschnitte, die gebogen werden;
- werden zwei oder drei Folien so strukturiert, dass sich bei deren Anordnung übereinander solche Bereiche ergeben, über deren gesamte Breite wenigstens hinsichtlich einer Folie keine Überlappung erfolgt oder dass wenigstens eine Folie in sich wiederholenden Teilbereichen über die gesamte Breite des Laminats nicht laminiert wird;
- sind zwei unterschiedlich strukturierte Metallfolien durch eine davon unterschiedlich strukturierte Kunststofffolie voneinander getrennt;
- besteht das bandförmige Laminat aus einer strukturierten Metallfolie zwischen zwei strukturierten Kunststofffolien, wobei die Folien unterschiedliche sich wiederholende Konturen aufweisen;
- wird eine strukturierte Metallfolie zwischen zwei identisch strukturierten Kunststofffolien angeordnet;
- werden aus dem Laminat sich wiederholende Abschnitte der sich wiederholenden Konturen aus der Bandfläche des Laminats zu bandenförmigen Laschen gebogen;
- werden die Laschen rechtwinklig oder fast rechtwinklig, insbesondere in einem Bereich zwischen 80° und 100° aus der Fläche des Bandes gebogen;
- werden metallische Laschen durch die Ebene eines Freischnitts der Kunststofffolie gebogen;
- werden die Konturen der metallischen Laschen sowie des Freischnitts in der Kunststofffolie vor der Laminierung der Kunststofffolie mit der Metallfolie erzeugt;
- werden aus diesem Laminat sich wiederholende Abschnitte der sich wiederholenden Konturen aus der Bandfläche des Laminats zu Z-förmigen Abstandshaltern gebogen;
- ragen die Abstandshalter höher aus der Bandfläche als die Laschen;
- umfasst ein Verfahren wenigstens zwei der Schritte A, B, und C;
- umfasst ein Verfahren die drei Schritte A, B und C;
- wird die Reihenfolge der Schritte A, B, und C eingehalten;
- wird eine Folie in solchen Bereichen, die über die gesamte Breite nicht mit der anderen Folie überlappen, in nicht zusammenhängende Konturen getrennt;
- werden im Laminat Module erzeugt, die einzig über metallische Anbindungen im Laminat gehalten sind;
- werden bandförmige Laminate zur Vereinzelung zu Substraten in den Bereichen getrennt, in denen eine Folie unterbrochen wurde;
- besteht das bandförmige Laminat aus zwei strukturierten Metall- und einer zwischen den Metallfolien angeordneten strukturierten Kunststofffolie, wobei die Folien jeweils unterschiedliche, sich wiederholende Muster aufweisen.

Erfindungsgemäß wird es ermöglicht, metallische Laschen durch die Ebene eines Freischnitts einer Kunststofffolie zu biegen, weil die Kontur für die Laschen und die Freischnitte in den jeweiligen Folien bereits vor dem Laminieren erstellt wurden. Die einzig verbleibenden metallischen Anbindungen der Module erlauben eine rückstandsfreie Trennung der Module beim Vereinzeln, wie dies für hochreine Anwendungen von Bedeutung ist. Damit wird vermieden, dass beim Vereinzeln Staub durch das Durchtrennen von kunststoffhaltigen Anbindungen entsteht.

Dies ermöglicht weiterhin, mehrere Laschen zueinander so anzuordnen, dass sie eine Halterung zur Aufnahme von elektronischen Bauteilen ausbilden. Die Laschen sind dabei die Wände der Halterung. Die Halterung kann durch die Laschen als Fassung ausgebildet sein, mit der elektronische Bauteile gefasst werden. Damit lassen sich Module mit Fassungen für elektrische Bauteile erzeugen. Die Module können noch auf dem Band mit besonders großer Präzision bestückt werden, bevor sie vereinzelt werden.

Im Folgenden wird die Erfindung in Bezug auf die Zeichnungen verdeutlicht:
- Fig. 1: zeigt eine gestanzte Metallfolie in Draufsicht,
- Fig. 2: zeigt eine gestanzte Kunststofffolie in Draufsicht,
- Fig. 3: zeigt ein Laminat aus der Metallfolie nach Fig. 1 und der Kunststofffolie nach Fig. 2 in Draufsicht,
- Fig. 4a: zeigt in Draufsicht das Laminat aus Fig. 3 mit hochgebogenen Laschen und hochgebogenen Abstandshaltern,
- Fig. 4b: zeigt einen Ausschnitt eines noch angebundenen Moduls aus Fig. 4a,
- Fig. 4c: zeigt in Seitenansicht das Laminat aus Fig. 3 mit hochgebogenen Laschen und hochgebogenen Abstandshaltern in der die aus der Fläche des Laminats gebogenen Laschen und Abstandshalter verdeutlicht sind,
- Fig. 4d: zeigt eine dreidimensionale Darstellung des Laminats aus Fig. 3 mit hochgebogenen Laschen und hochgebogenen Abstandshaltern und mit runden Führungslöchern,
- Fig. 5: zeigt das Vereinzeln der laminierten Module aus dem laminierten Band.

Im Folgenden werden die Schritte des Herstellungsprozesses mit der Figurenfolge verdeutlicht.

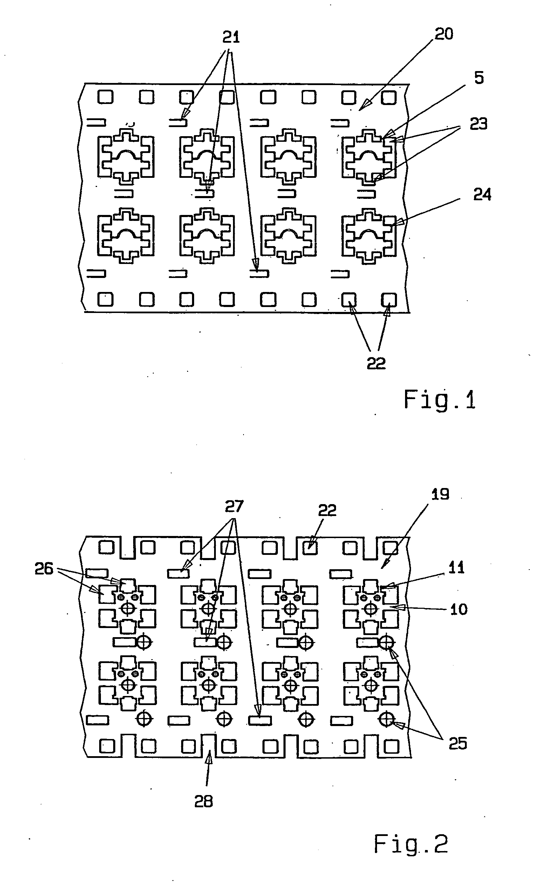

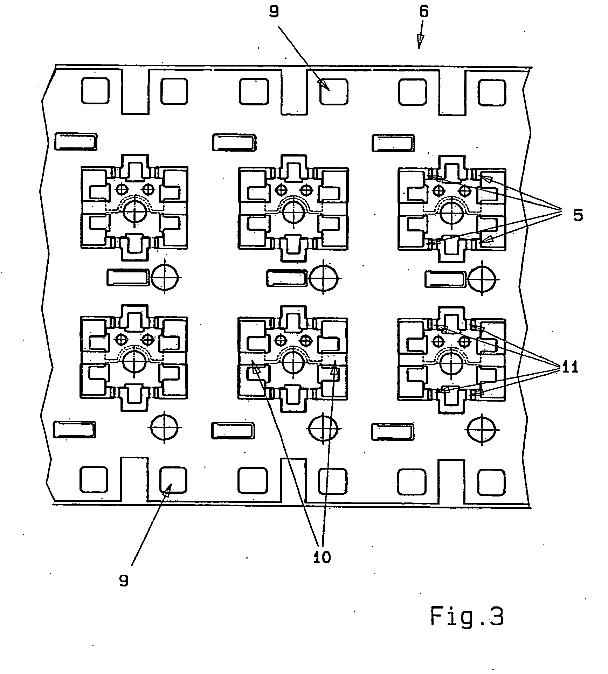

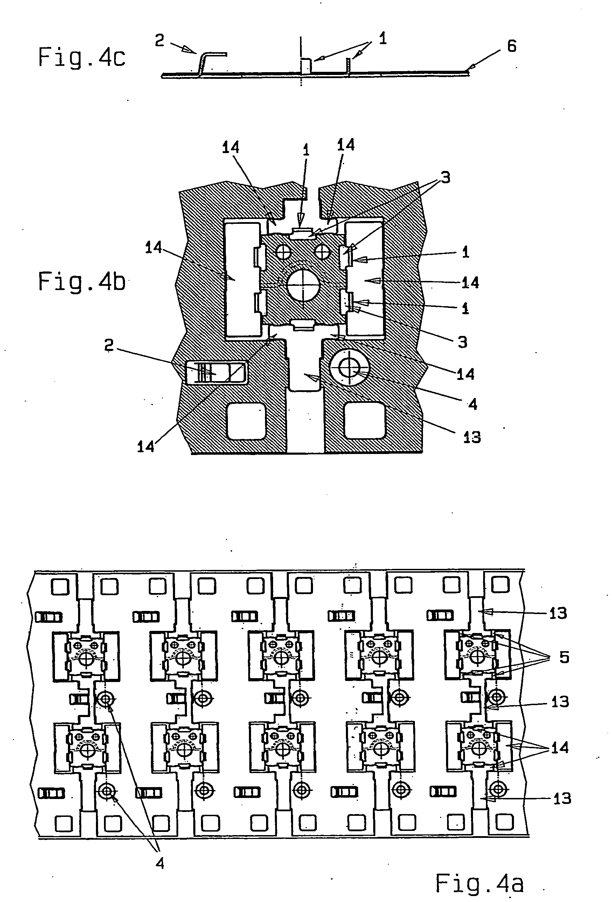

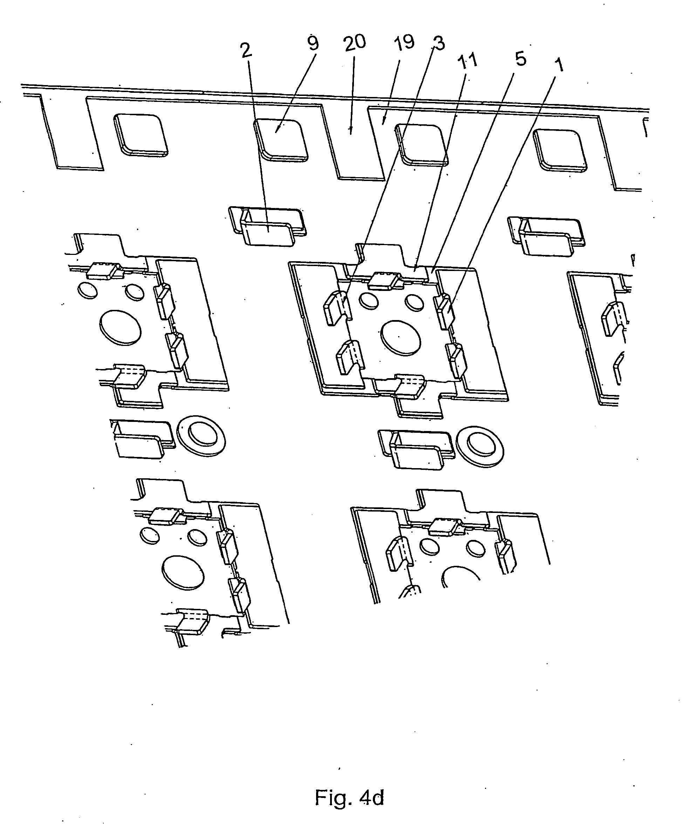

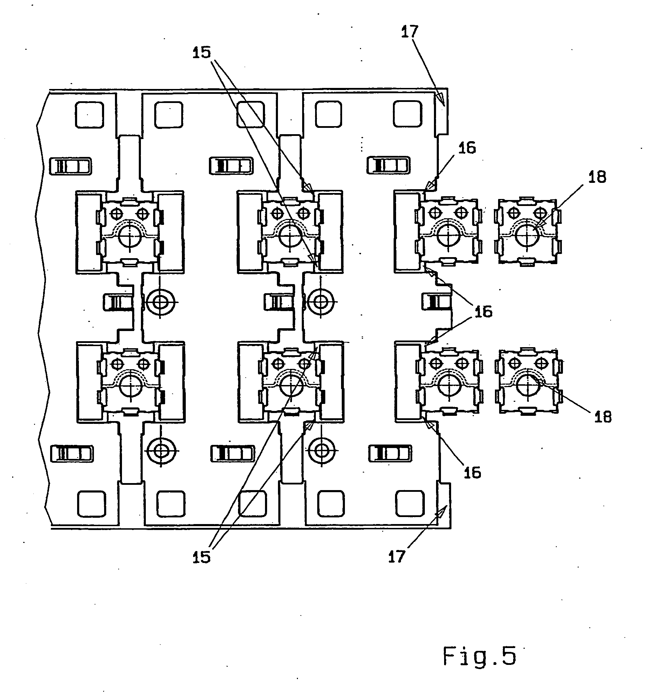

Zur Herstellung einer Metallfolie 20 nach Fig. 1 wird in einer Stanzeinrichtung eine Stanzfolge durchgeführt, die wiederkehrende Konturen 21, 22, 23, 24 in Form von Stanzbildern gemäß Fig. 1 aufweist. Entsprechend lassen sich Metallfolien nach Fig. 1 ohne die Abstandshalterumrisslinie auch durch Ätzen strukturieren. Analog werden nach Fig. 2 andere Konturen 25, 26, 27, 28 in Form von Stanzbildern mit einem anderen Stanzwerkzeug in eine Kunststofffolie 19 gestanzt. Die Folien gemäß Fig. 1 und Fig. 2 werden mittels ihrer Führungslöcher 22 zu einem Metall-Kunststoff-Folienverbund 6 gemäß Fig. 3 und 4c laminiert. Die Umrisslinien 21, 22, 23, 24, 25, 26, 27, 28 der Metallfolie 20 und der Kunststofffolie 19 werden dabei passgenau zu Strukturen laminiert, die die Struktur der späteren Module 18 erzeugen. Aus dem Laminat 6 gemäß Fig. 3 werden im Bereich der Laschen 24 die Kunststoffanbindungen 10 herausgetrennt. Danach werden die Laschen 24 hochgebogen. Die hoch gebogenen Laschen 1 sind in Fig. 4a, b, c und d ersichtlich. Das Laminat nach Fig. 4a, b, c, d ist geeignet zur Bestückung mit elektronischen Bauteilen und kann gem. Fig. 5 durch Abtrennen der metallischen Anbindungen 5 an den Trennstellen 15 und 16 zu einzelnen Modulen 18 vereinzelt werden.

Fig. 1 zeigt als Kontur 23 den Freischnitt 23 um die später gebogenen Laschen 1. Zwischen den Konturen 23, die die Freischnitte 23 erzeugen, befinden sich Anbindungen 5, die die Anbindung der durch die Freischnitte 23 erzeugten Inseln der späteren Module 18 mit dem äußeren Bereich der Metallfolie 20 aufrecht halten. Die Kontur 21 der Abstandshalter ist ein gestanzter Schnitt 21 für Abstandshalter 2. Die Konturen 22 sind ausgestanzte Führungslöcher 22. Die Metallfolie 20 ist im Bereich von Abstandshaltern 2 gemäß Fig. 1 nur eingeschnitten. Hierfür werden die Abstandshalter 2 nach dem passgenauen Schnitt 21 in die Fläche der Metallfolie zurückgedrückt. Die Kontur 24 definiert die später gebogenen Laschen 1.

Fig. 2 zeigt die Konturen 25, 26, 27, 28 in der Kunststofffolie 19 als die Freischnitte 25, 26, 27, 28 im Bereich der späteren Laschen 24, Abstandshalter 2, Referenzlöcher 4 und die ausgestanzten Führungslöcher 22. Die Freischnitte legen somit Laschen 24, die Abstandshalter 2 und die Referenzlöcher 4 frei. Weiterhin sind Ausnehmungen 28 am Rand ausgestanzt. Die Kontur 25 ist ein Freischnitt in der Kunststofffolie 19 zum späteren Stanzen der Referenzlöcher 4 in die Metallfolie 20. Die Kontur 26 ist ein Freischnitt in der Kunststofffolie 19, der das spätere Biegen der gestanzten Laschen 24 zu Laschen 1 ermöglicht. Zwischen den Konturen 26, die die Freischnitte 26 erzeugen, befinden sich Anbindungen 10 und 11, die die Anbindung der durch die Freischnitte 26 erzeugten Inseln der späteren Module 18 mit dem äußeren Bereich der Kunststofffolie 19 aufrecht halten. Die Kontur 27 ist analog der Kontur 26 ein Freischnitt, der das spätere Biegen der Abstandshalter durch die Ebene des Freischnitts hindurch ermöglicht. Die Kontur 28 dient als Freischnitt mit den Freischnitten 26 gemäß Konturen 26 dem späteren Vereinzeln der Module durch nachfolgende Freischnitte 13 (Fig. 4b).

Fig. 3 zeigt metallische Anbindungen 5, die aufgrund der Freischnitte 26 von der Kunststofffolie 19 nicht abgedeckt sind. Die Führungslöcher 22 der Metall- und Kunststofffolie sind im Laminat 6 passgenau übereinander als Führungslöcher 9 laminiert. Die Kunststoffanbindungen 10 und 11 sind aufgrund der Freischnitte 23 nicht auf der Metallfolie laminiert.

Nach dem Laminieren der Folien 19 und 20 zu einem Laminat 6 gemäß Fig. 3 (und 4c) werden zuerst die Anbindungen 10 und 11 der Kunststofffolie 19 an den Trennstellen 14 ausgestanzt und danach die Laschen 24 und die Abstandshalter 21 aus der Fläche des Laminats gebogen.

Aus der Fläche gebogene Laschen 1 und Abstandshalter 2 sind in Fig. 4a, b, c, d ersichtlich. Der Freischnitt 3 ist ein Teil des Freischnitts 26, durch den ein Anliegen der Lasche 1 an der Schnittkante der Kunststofffolie 19 vermieden wird. Hierdurch wird erfindungsgemäß eine besonders bevorzugte Präzision bezüglich der Biegung der Lasche geschaffen. Nach den Biegevorgängen erfolgt ein Freischneiden der verbliebenen Laminatanbindungen 13. Damit ist das Modul 18 hinsichtlich seiner Kunststofflaminierung fertiggestellt und ist nur noch über die Metallfolie 20 in der Bandstruktur gehalten und zwar über seine metallischen Anbindungen 5 (gemäß Fig. 4a und 4d) an den Trennstellen 15, 16 und 17, wie aus Fig. 5 ersichtlich ist. Die Module des Trägerbands nach Fig. 5 sind für eine automatische Bestückung geeignet. Für diesen Fall werden separate Referenzlöcher 4 mit einer Präzision im Bereich von ± 0,01 mm erstellt, die nach dem Biegen der Laschen 24 zu 1 und Abstandshalter 21 zu 2 in die Metallfolie gestanzt werden. Die Referenzlöcher 4 erlauben eine präzise Bestückung der Module 18 mit Bauteilen. Die Position der gebogenen Laschen 1 ist durch die Referenzlöcher 4 besonders genau definiert. Eine derartige Anordnung eignet sich besonders für die Bestückung mit elektronischen Bauteilen. Zusätzlich zu den bekannten Kontaktierungen über die Basis der Metallfolie ermöglicht die erfindungsgemäße Ausführung mit Laschen auch eine Kontaktierung über die Laschen 1.

Die erfindungsgemäße Möglichkeit, nicht nur über die Basisfläche der Metallfolie zu kontaktieren, sondern auch eine Kontaktierung über die Seiten zu gestatten, eröffnet neue Montage- und Bestückungsmöglichkeiten sowie den Einsatz von elektronischen Bauteilen neuen Designs. Weiterhin ermöglichen die Laschen 1 eine mechanische Fixierung sowie Schutz vor mechanischen Belastungen. Der Schutz ist dabei sowohl für weitere Fertigungsverfahren, wie zum Beispiel Umspritzen der montierten Bauteile, als auch in der Endanwendung gegeben. Die Haltefunktion der Laschen 1 ist dabei nicht auf elektronische Bauteile beschränkt.

Nach dem Bestücken mit den Bauteilen werden die in der Metallfolie 20 gehaltenen Module 18 vereinzelt. Die Vereinzelung erfolgt durch Freischneiden der verbliebenen metallischen Anbindungen an den Trennstellen 15, 16 und 17, so dass in diesem Schritt kein Laminat geschnitten wird und dieser Verfahrensschritt unter Reinstraum-Bedingungen durchgeführt werden kann.

### Bezugszeichenliste

1) gebogene Laschen
2) gebogene Abstandshalter
3) Freischnitt der Kunststofffolie im Biegebereich der Laschen
4) Nach dem Biegen gestanztes Referenzloch
5) Metallische Anbindung der Module
8) Laminiertes Substrat
9) Führungslöcher (passgenau laminiert)
10) Anbindung der Kunststofffolie
11) Anbindung der Kunststofffolie
13) Trennstelle der Laminatanbindung
14) Trennstelle der Kunststoffanbindung
15) Trennstelle
16) Trennstelle
17) Trennstelle
18) Modul
19) Kunststofffolie
20) Metallfolie
21) Kontur der Abstandshalter
22) Führungslöcher
23) Freischnitt in der Metallfolie um noch zu biegende Laschen
24) Laschen (gestanzt/flach)
25) Freischnitte in der Kunststofffolie zum späteren Stanzen der Referenzlöcher
26) Freischnitte in der Kunststofffolie zum späteren Biegen der Laschen
27) Freischnitte in der Kunststofffolie zum späteren Biegen der Abstandshalter
28) Freischnitt in der Kunststofffolie zum späteren Vereinzeln der Module

## Patentansprüche

1. Verfahren zur Herstellung laminierter Substrate (6) für die Halbleiterchip-Montage, mit den Schritten:
- Bereitstellen einer gestanzten Metallfolie (20), die wiederkehrende Konturen (21, 22, 23, 24) aufweist,
- Bereitstellen einer gestanzten Kunststofffolie (19), die andere Konturen (25, 26, 27, 28) aufweist,
- wobei die Metall- und die Kunststofffolie (20, 19) mit jeweils unterschiedlichen, sich wiederholenden Konturen (23, 26) zu einem laminierten Substrat (6) laminiert werden,
- und nach dem Laminieren Löcher (4) oder Schnitte (13, 14) erzeugt werden,
**gekennzeichnet dadurch, dass**
sich wiederholende Abschnitte der sich wiederholenden Konturen (21, 24) aus der Bandfläche des laminierten Substrats (6) gebogen werden,
wobei die Löcher (4) oder Schnitte (13, 14) derart erzeugt werden, dass
• die Folien (19 20) so strukturiert werden, dass sich bei dem laminierten Substrat (6) nachfolgende Freischnitte (13) ergeben, bei denen über die gesamte Breite des laminierten Substrats (6) keine Überlappung der Kunststofffolie (19) über die Metallfolie (20) erfolgt,
• im laminierten Substrat Module (18) erzeugt werden, die einzig über metallische Anbindungen (5) im laminierten Substrat gehalten sind, und
• die Module (18) hinsichtlich der Kunststofflaminierung fertiggestellt und nur noch über die Metallfolie (20) in dem laminierten Substrat (6) gehalten werden, und zwar über die metallischen Anbindungen (5),
• wobei die metallischen Anbindungen (5) aufgrund der Freischnitte (13) von der Kunststofffolie (19) nicht abgedeckt sind.

2. Verfahren nach Anspruch 1, **dadurch gekennzeichnet, dass** sich wiederholende Abschnitte zu Laschen (1) gebogen werden.

3. Verfahren nach einem der vorhergehenden Ansprüche, **dadurch gekennzeichnet, dass** sich wiederholende Abschnitte zu Abstandshaltern (2) gebogen werden.

4. Verfahren nach einem der vorhergehenden Ansprüche, **dadurch gekennzeichnet, dass** Referenzlöcher (4) in die Metallfolie (20) gestanzt werden.

5. Verfahren nach einem der vorhergehenden Ansprüche, **dadurch gekennzeichnet, dass** eine erste Vereinzelung der Kunststofffolie (19) in voneinander getrennte Konturen (18) durchgeführt wird, während die Metallfolie (20) die Bandstruktur aufrecht hält.

6. Verfahren nach Anspruch 2, **dadurch gekennzeichnet, dass** die Lasche (1) durch eine Ebene eines Freischnitts (26) gebogen wird.

7. Verfahren nach Anspruch 2 oder 6, **dadurch gekennzeichnet, dass** eine Kontur (23) zur Erstellung der Lasche (1) durch Strukturierung der Metallfolie (20) vor der Laminierung mit der Kunststofffolie (19) erfolgt.

8. Verfahren nach einem der vorhergehenden Ansprüche, **dadurch gekennzeichnet, dass** der Freischnitt (26) in der Kunststofffolie durch Strukturierung der Kunststofffolie (19) vor dem Laminieren der Kunststofffolie (19) mit der Metallfolie (20) erfolgt.

9. Laminiertes Substrat (6) aus mindestens je einer strukturierten Metall- und einer Kunststofffolie (20, 19) hergestellt nach einem Verfahren gemäß mindestens einem der Ansprüche 1 bis 8, wobei die Folien jeweils unterschiedliche, sich wiederholende Konturen (23, 26) aufweisen, wobei das laminierte Substrat (6) Module (18) aufweist, die nur noch über die Metallfolie (20) in dem laminierten Substrat (6) gehalten werden, und zwar über die metallischen Anbindungen (5).

## Claims

1. Method for producing laminated substrates (6) for semiconductor chip assembly, including the steps:
- providing a punched metal foil (20) comprising repetitive contours (21, 22, 23, 24);
- providing a punched plastic film (19) comprising different contours (25, 26, 27, 28);
- whereby the metal foil and the plastic film (20, 19) comprising different repetitive contours (23, 26) each are laminated to form a laminated substrate (6);
- and holes (4) or cuts (13, 14) are generated after the lamination;
**characterised in that**
repetitive sections of the repetitive contours (21, 24) are bent out of the ribbon surface of the laminated substrate (6),
whereby the holes (4) or cuts (13, 14) are generated such that
• the foil(s) or film(s) (19, 20) are structured such that subsequent relief cuts (13), in which there is no overlap of the plastic film (19) over the metal foil (20) over the entire width of the laminated substrate (6), arise in the laminated substrate (6),
• modules (18), which are held in the laminated substrate solely through metallic connections (5), are generated in the laminated substrate, and
• the modules (18) are finished with regard to plastic lamination and are held in the laminated substrate (6) solely through the metal foil (20), namely through the metallic connections (5),
• whereby the metallic connections (5) are not covered by the plastic film (19) owing to the relief cuts (13).

2. Method according to claim 1, **characterised in that** repetitive sections are being bent into straps (1).

3. Method according to any one of the preceding claims, **characterised in that** repetitive sections are being bent into spacers (2).

4. Method according to any one of the preceding claims, **characterised in that** reference holes (4) are being punched into the metal foil (20).

5. Method according to any one of the preceding claims, **characterised in that** a first separation of the plastic film (19) into contours (18) that are separate from each other is carried out while the metal foil (20) maintains the ribbon structure.

6. Method according to claim 2, **characterised in that** the strap (1) is bent through a plane of a relief cut (26).

7. Method according to claim 2 or 6, **characterised in that** a contour (23) for generating the strap (1) is made through structuring the metal foil (20) prior to lamination to the plastic film (19).

8. Method according to any one of the preceding claims, **characterised in that** the relief cut (26) in the plastic film is made through structuring the plastic film (19) prior to laminating the plastic film (19) to the metal foil (20).

9. Laminated substrate (6) made of at least one structured metal foil and one plastic film (20, 19) each, produced according to a method according to at least one of the claims 1 to 8, whereby the foil(s) and film(s) each comprise different repetitive contours (23, 26), whereby the laminated substrate (6) comprises modules (18) that are held in the laminated substrate (6) solely through the metal foil (20), namely through the metallic connections (5).

## Revendications

1. Procédé de fabrication de substrats stratifiés (6) pour le montage de puces semiconductrices, comprenant les étapes :
- fourniture d'un film métallique découpé (20) qui présente des contours répétitifs (21, 22, 23, 24),
- fourniture d'un film plastique découpé (19) qui présente d'autres contours (25, 26, 27, 28),
- dans lequel le film métallique et le film plastique (20, 19) avec des contours à chaque fois différents, se répétant (23, 26) sont stratifiés en un substrat stratifié (6),
- et des orifices (4) ou découpes (13, 14) sont produits après la stratification,
**caractérisé en ce que**
des sections se répétant des contours se répétant (21, 24) sont courbées depuis la surface d'attache du substrat stratifié (6),
dans lequel les orifices (4) ou découpes (13, 14) sont produits de telle sorte que
• les films (19, 20) sont structurés de sorte qu'il en résulte des dégagements subséquents (13) pour le substrat stratifié (6) pour lesquels aucun chevauchement du film plastique (19) au-dessus du film métallique (20) n'a lieu sur toute la largeur du substrat stratifié (6),
• des modules (18) qui sont maintenus individuellement par le biais d'attaches métalliques (5) dans le substrat stratifié sont générés dans le substrat stratifié, et
• les modules (18) sont mis à disposition en ce qui concerne la stratification plastique et maintenus dans le substrat stratifié (6) uniquement par le biais du film métallique (20), et ce par le biais des attaches métalliques (5),
• dans lequel les attaches métalliques (5) ne sont pas recouvertes par le film plastique (19) en raison des dégagements (13).

2. Procédé selon la revendication 1, **caractérisé en ce que** des sections se répétant sont courbées en des brides (1).

3. Procédé selon l'une quelconque des revendications précédentes, **caractérisé en ce que** des sections se répétant sont courbées en des écarteurs (2).

4. Procédé selon l'une quelconque des revendications précédentes, **caractérisé en ce que** des orifices de référence (4) sont découpés dans le film métallique (20).

5. Procédé selon l'une quelconque des revendications précédentes, **caractérisé en ce qu'**un premier isolement du film plastique (19) dans des contours séparés les uns des autres (18) est réalisé tandis que le film métallique (20) maintient verticalement la structure d'attache.

6. Procédé selon la revendication 2, **caractérisé en ce que** les brides (1) sont courbées par un plan d'un dégagement (26).

7. Procédé selon la revendication 2 ou 6, **caractérisé en ce qu'**un contour (23) pour la création des brides (1) est généré par structuration du film métallique (20) avant la stratification avec le film plastique (19).

8. Procédé selon l'une quelconque des revendications précédentes, **caractérisé en ce que** le dégagement (26) dans le film plastique est généré par structuration du film plastique (19) avant la stratification du film plastique (19) avec le film métallique (20).

9. Substrat stratifié (6) constitué d'au moins à chaque fois un film métallique et un film plastique structurés (20, 19) fabriqué selon un procédé selon au moins une des revendications 1 à 8, dans lequel les films présentent des contours à chaque fois différents, se répétant (23, 26), dans lequel le substrat stratifié (6) présente des modules (18) qui sont maintenus dans le substrat stratifié (6) uniquement par le biais du film métallique (20), et ce par le biais des attaches métalliques (5).
